# EUROPÄISCHE PATENTSCHRIFT

(11) **EP 3 794 699 B1**
(45) Veröffentlichungstag und Bekanntmachung des Hinweises auf die Patenterteilung: **30.10.2024**
(21) Anmeldenummer: 19778845.8
(22) Anmeldetag: 16.09.2019
(51) Int. Cl.: H02H 1/04, H02H 3/02, H02H 3/087, H02H 7/16, H02H 7/22, H02H 9/00, H02H 9/02, H02J 1/00

(54) **VORRICHTUNG UND VERFAHREN ZUM KOPPELN ZWEIER GLEICHSTROMNETZE**
DEVICE AND METHOD FOR COUPLING TWO DC GRIDS
DISPOSITIF ET PROCÉDÉ DE COUPLAGE DE DEUX RÉSEAUX À COURANT CONTINU

(30) Priorität: 19.09.2018 DE 102018215881
(43) Veröffentlichungstag der Anmeldung: 24.03.2021
(73) Patentinhaber: Siemens Aktiengesellschaft, 80333 München (DE)
(72) Erfinder: RUPP, Jürgen, Verstorben (DE)
(74) Vertreter: Siemens Patent Attorneys
(86) Internationale Anmeldenummer: PCT/EP2019/074642
(87) Internationale Veröffentlichungsnummer: WO 2020/058162

(56) Entgegenhaltungen:
- EP-A1- 0 867 998
- EP-A1- 3 367 567
- WO-A1-2018/158233
- WO-A2-2011/095212
- DE-A1- 102015 102 481
- DE-B3- 102017 202 103
- US-A1- 2017 063 077

## Beschreibung

Die Erfindung betrifft eine Vorrichtung und ein Verfahren zum Koppeln zweier quell- und lastseitige Kapazitäten umfassenden Gleichstromnetze mittels einer Schaltvorrichtung zur Stromregelung.

Gleichstromnetze, auch als DC-Netze bezeichnet, umfassen häufig große Kapazitäten, wie z.B. Zwischenkreiskondensatoren von Umrichtern. Werden zwei quell- und lastseitige Kapazitäten umfassende Gleichstromnetze miteinander verbunden, wobei eine der Kapazitäten bereits auf Betriebsspannung liegt, während die in dem anderen Gleichstromnetz noch entladen ist, treten bei einer direkten Verbindung der beiden Gleichstromnetze sehr hohe Ausgleichsströme auf.

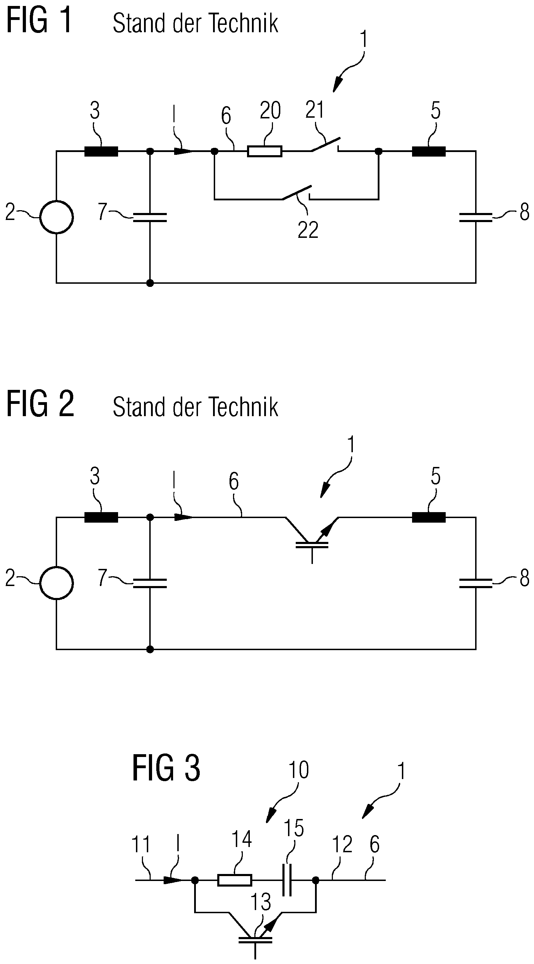

Um diese Ströme in ihrer Höhe zu begrenzen, erfolgt die Verbindung zweier quell- und lastseitiger Kapazitäten umfassenden Gleichstromnetze über geeignete Schaltvorrichtungen, wie dies in den elektrischen Ersatzschaltbildern der Figuren 1 und 2 gezeigt ist.

Fig. 1 zeigt das elektrische Ersatzschaltbild einer Schaltvorrichtung 1, welche über eine quellseitige Induktivität 3 mit einer Gleichspannungsquelle 2 verbunden ist. Parallel zu der Serienschaltung aus der Gleichspannungsquelle 2 und der quellseitigen Induktivität 3 ist eine quellseitige Kapazität 7 vorgesehen. Ausgangsseitig ist die Schaltvorrichtung 1 über eine lastseitige Induktivität 5 mit einer lastseitigen Kapazität 8 verbunden. Die quell- und lastseitigen Induktivitäten 3, 5 müssen nicht zwingend physikalische Komponenten der beiden über die Schaltvorrichtung 1 verbundenen Gleichspannungsnetze darstellen. Die quell- und lastseitigen Induktivitäten 3, 5 können auch Leitungsinduktivitäten sein. Die quell- und lastseitigen Kapazitäten 7, 8 sind z.B. Zwischenkreiskondensatoren von nicht dargestellten Umrichtern.

In der in Fig. 1 gezeigten, bekannten Variante einer Schaltvorrichtung 1 wird die Verbindung zwischen den beiden Gleichspannungsnetzen zunächst über einen Ladewiderstand 20 hergestellt. Der Ladewiderstand 20 ist in Serie zu einem Schaltelement 21 verschaltet und dient dazu, den Strom I zu begrenzen und eine Beschädigung der Komponenten zu vermeiden. Erst, wenn sich die Spannung zwischen den beiden Schienen der Gleichstromnetze soweit angenähert hat, dass eine niederohmige Verbindung möglich ist, wird der Ladewiderstand 20 mit einem Hauptschalter 22 überbrückt. Der Schalter 21 wird auch als Vorlade-Schalter bezeichnet.

In der in Fig. 2 gezeigten Variante umfasst die Schaltvorrichtung 1 ein einziges Halbleiterschaltelement, so dass ein Ladestrom I durch getaktetes Ein- und Ausschalten des Halbleiterschaltelements eingestellt werden kann. Durch Variation der Frequenz und des Pulsweitenverhältnisses kann die Ladungsmenge pro Zeit und damit der mittlere Ladestrom eingestellt werden. Damit kommt es aber je Impedanz der Verbindung zu hohen Stromspitzen. Diese Variante weist zudem einen Nachteil auf, wenn zwischen der quell- und lastseitigen Kapazität 7, 8 eine lediglich kleine Induktivität oder ein Widerstand vorhanden ist.

Es ist Aufgabe der vorliegenden Erfindung, eine Vorrichtung und ein Verfahren zum Koppeln zweier quell- und lastseitige Kapazitäten aufweisenden Gleichstromnetze mittels einer Schaltvorrichtung zur Stromregelung anzugeben, welche baulich und/oder funktionell verbessert sind.

Diese Aufgaben werden gelöst durch eine Vorrichtung gemäß den Merkmalen des Anspruches 1 sowie ein Verfahren gemäß den Merkmalen des Anspruches 8. Vorteilhafte Ausgestaltungen ergeben sich aus den abhängigen Ansprüchen.

Es wird eine Vorrichtung zum Koppeln zweier quell- und lastseitige Kapazitäten umfassenden Gleichstromnetze mittels einer Schaltvorrichtung zur Stromregelung vorgeschlagen. Die Schaltvorrichtung umfasst zwei in Serie verschaltete Schaltmodule, wobei jedes der Schaltmodule zumindest ein steuerbares Halbleiterschaltelement umfasst, dem eine Serienschaltung aus einem Widerstand und einem Kondensator parallel geschaltet ist.

Eine derartige Schaltvorrichtung ist aus der WO 2018/158233 A1 der Anmelderin bekannt. Die dort beschriebene Schaltvorrichtung, die zumindest zwei in Serie verschaltete Schaltmodule umfasst, dient dazu, einen "weichen" Abschaltvorgang in einem quell- und lastseitige Induktivitäten umfassenden Strompfad vornehmen zu können. Die Schaltvorrichtung ermöglicht es, den Stromfluss in dem Strompfad nicht abrupt, sondern rampenförmig abzubauen. Durch wenigstens eines der zumindest zwei Schaltmodule wird eine Gegenspannung im Strompfad aufgebaut. Dies wird durch einen Betrieb des jeweiligen Halbleiterschaltelements der Schaltmodule im getakteten Bereich ermöglicht. Damit wird die hohe Verlustleistung im Abschaltfall nicht in dem Halbleiterschaltelement der jeweiligen Schaltmodule umgesetzt, sondern überwiegend in dem Widerstand der jeweiligen Schaltmodule. Die Schaltvorrichtung kann dadurch auf spannungsbegrenzende Bauelemente, wie Varistoren, verzichten, die teuer, schwer und bauraumintensiv sind. Das Halbleiterschaltelement in den jeweiligen Schaltmodulen übernimmt dabei die Rolle eines Choppers. Die prinzipiell bekannte Schaltvorrichtung wird erfindungsgemäß zum Koppeln zweier quell- und lastseitige Kapazitäten umfassenden Gleichstromnetze genutzt. Dabei wird der Chopper-Betrieb nicht beim Trennen der beiden DC-Netze verwendet, um den Strom langsam abzubauen, sondern beim Verbinden (Einschalten) der beiden DC-Netze, um den Ladestrom zu begrenzen. Erfindungsgemäß ist eine Steuereinheit vorgesehen, die dazu ausgebildet ist,
a) das steuerbare Halbleiterschaltelement eines der beiden Schaltmodule leitend zu schalten und gleichzeitig das steuerbare Halbleiterschaltelement des anderen der beiden Schaltmodule sperrend zu schalten;
b) das steuerbare Halbleiterschaltelement des anderen der beiden Schaltmodule leitend zu schalten und gleichzeitig das steuerbare Halbleiterschaltelement des einen der beiden Schaltmodule sperrend zu schalten;
c) die Schritte a) und b) solange zu wiederholen, bis sich die Spannungen der quell- und lastseitigen Kapazitäten aneinander angeglichen haben; und
d) die steuerbaren Halbleiterschaltelemente der zwei Schaltmodule leitend zu schalten.

Dieser Betrieb der zumindest zwei in Serie verschalteten Schaltmodule erlaubt es, einen Ausgleichsvorgang der quell- und lastseitigen Kapazitäten vorzunehmen, bevor die zwei Gleichstromnetze über die Schaltelemente der Schaltmodule dauerhaft miteinander verbunden werden. Das Auftreten hoher Ausgleichsströme kann auf diese Weise vermieden werden.

Um den Strom weiter zu begrenzen, kann optional vorgesehen sein, beide Halbleiterschaltelemente nach Schritt b) gleichzeitig sperrend zu schalten (Schritt b1). Bei dieser Ausgestaltung werden dann die Schritte a), b) und b1) solange wiederholt, bis sich die Spannungen der quell- und lastseitigen Kapazitäten aneinander angeglichen haben.

Zweckmäßigerweise ist die Steuereinheit dazu ausgebildet, die Schritte a) und b) zeitlich hintereinander durchzuführen. Die Schritte a) und b) werden somit abwechselnd solange wiederholt, bis sich die Spannungen der quell- und lastseitigen Kapazitäten aneinander angeglichen haben.

Die Steuereinheit ist ferner dazu ausgebildet, durch die Zeitdauer der Durchführung der Schritte a) und/oder b) den mittleren Strom von dem einen der beiden Gleichstromnetze in das andere der beiden Gleichstromnetze einzustellen.

Alternativ oder zusätzlich ist die Steuereinheit dazu ausgebildet, durch ein Pulsweitenverhältnis der in den Schritten a) und/oder b) leitend geschalteten steuerbaren Halbleiterschaltmodule den Maximalstrom von dem einen Gleichstromnetz in das andere Gleichstromnetz einzustellen. Durch jede der beiden Varianten kann im Ergebnis auch die Zeitdauer bis zum Angleichen der Spannungen der quell- und lastseitigen Kapazitäten bestimmt werden. Der maximal auftretende Spitzenstrom wird ungeachtet der Wirkung vorhandener Netz-Impedanzen dadurch begrenzt, dass während des Schaltvorganges immer mindestens einer der Widerstände der Halbleiterschaltmodule im Stromkreis liegt. Damit ist der Maximalstrom statisch begrenzt, ohne dass Induktivitäten benötigt werden.

Es ist weiterhin zweckmäßig, wenn eines der zwei Gleichstromnetze eine mittels eines steuerbaren Schalters schaltbare kapazitive Last umfasst, wobei die Steuereinheit dazu ausgebildet ist, die Schaltvorrichtung zur Stromregelung im Chopper-Betrieb zu betreiben, wenn die Steuereinheit von dem steuerbaren Schalter ein Signal empfängt, das einen Kurzschluss signalisiert. Durch den durch den Ausgleichsvorgang verursachten (Lade-)Strom kann in einer integrierten Überwachungseinheit des steuerbaren Schalters fälschlicherweise ein Kurzschluss detektiert werden und zur Abschaltung des steuerbaren Schalters führen. Dieses aus Sicherheitsgründen vorgenommene Abschalten kann jedoch vermieden werden, wenn nicht sofort der steuerbare Schalter, der in Serie zu der schaltbaren kapazitiven Last vorgesehen ist, abgeschaltet wird, sondern zunächst im Chopper-Mode eine Strombegrenzung erreicht wird. Dadurch bleibt Zeit, um zu detektieren, ob tatsächlich ein Kurzschluss vorliegt oder nur vorübergehend ein erhöhter Ladestrom bzw. Ausgleichsstrom zwischen den beiden Gleichstromnetzen.

Hierzu kann die Steuereinheit dazu ausgebildet sein, den Stromverlauf auszuwerten, der von dem anderen der zwei Gleichstromnetze zu dem einen der zwei Gleichstromnetze mit der schaltbaren kapazitiven Last fließt. Alternativ oder zusätzlich kann vorgesehen sein, dass die Steuereinheit dazu ausgebildet ist, den Spannungsverlauf während des Chopper-Betriebs der Schaltvorrichtung auszuwerten. Beim Zuschalten der kapazitiven Last wird die Spannung nur kurz einbrechen, während bei einem Kurzschluss die detektierte Spannung dauerhalf einbricht.

Gemäß einem anderen Aspekt wird ein Verfahren zum Koppeln zweier quell- und lastseitige Kapazitäten umfassenden Gleichstromnetzen mittels einer Schaltvorrichtung zur Stromregelung vorgeschlagen. Die Schaltvorrichtung umfasst zwei in Serie verschaltete Schaltmodule, wobei jedes der Schaltmodule zumindest ein steuerbares Halbleiterschaltelement umfasst, dem eine Serienschaltung aus einem Widerstand und einem Kondensator parallel geschaltet ist. Durch die Steuereinheit der Schaltvorrichtung wird/werden:
a) das steuerbare Halbleiterschaltelement eines der beiden Schaltmodule leitend geschaltet und gleichzeitig das steuerbare Halbleiterschaltelement des anderen der beiden Schaltmodule sperrend geschaltet;
b) das steuerbare Halbleiterschaltelement des anderen der beiden Schaltmodule leitend geschaltet und gleichzeitig das steuerbare Halbleiterschaltelement des einen der beiden Schaltmodule sperrend geschaltet;
c) die Schritte a) und b) solange wiederholt, bis sich die Spannungen der quell- und lastseitigen Kapazitäten aneinander angeglichen haben; und
d) die steuerbaren Halbleiterschaltelemente der zwei Schaltmodule leitend geschaltet.

Das Verfahren weist die gleichen Vorteile auf, wie diese oben in Verbindung mit der erfindungsgemäßen Vorrichtung beschrieben wurden.

In einer Ausgestaltung führt die Steuereinheit die Schritte a) und b) zeitlich hintereinander durch.

Wenn die Steuereinheit dazu ausgebildet ist, beide Halbleiterschaltelemente nach Schritt b) gleichzeitig sperrend zu schalten (Schritt b1), dann werden die Schritte a), b) und b1) solange wiederholt, bis sich die Spannungen der quell- und lastseitigen Kapazitäten aneinander angeglichen haben.

Die Steuereinheit passt gemäß einer weiteren Ausgestaltung die Zeitdauern der Durchführung der Schritte a) und/oder b) an, um den mittleren Strom von dem einen Gleichstromnetz in das andere Gleichstromnetz auf einen bestimmten Wert einzustellen.

Die Steuereinheit passt gemäß einer weiteren Ausgestaltung ein Pulsweitenverhältnis der in den Schritten a) und/oder b) leitend geschalteten steuerbaren Halbleiterschaltmodule an, um den Maximalstrom von dem einen Gleichstromnetz in das andere Gleichstromnetz einzustellen.

Umfasst eines der zwei Gleichstromnetze eine mittels eines steuerbaren Schalters schaltbare kapazitive Last, wird die Schaltvorrichtung zur Stromregelung im Chopper-Betrieb betrieben, wenn die Steuereinheit von dem steuerbaren Schalter ein Signal empfängt, das einen Kurzschluss signalisiert. Die Steuereinheit kann dann den Stromverlauf auswerten, der von dem anderen der zwei Gleichstromnetze zu dem einen der zwei Gleichstromnetze mit der schaltbaren kapazitiven Last fließt. Alternativ oder zusätzlich wertet die Steuereinheit den Spannungsverlauf während des Chopper-Betriebs der Schaltvorrichtung aus.

Es wird ferner ein Computerprogrammprodukt vorgeschlagen, das in den internen Speicher einer Recheneinheit geladen werden kann und Codeabschnitte umfasst, mit denen das hierin beschriebene Verfahren durchgeführt wird, wenn das Programm auf der Recheneinheit läuft. Das Computerprogrammprodukt kann in der Gestalt eines Speichermediums, z.B. einer DVD, einer CD-ROM oder eines USB-Speichersticks verkörpert sein. Ebenso kann das Computerprogrammprodukt als ein über ein drahtloses oder leitungsgebundenes Kabel ladbares Signal vorliegen.

Die Erfindung wird nachfolgend näher anhand von Ausführungsbeispielen in der Zeichnung erläutert. Es zeigen:
- Fig. 1: ein elektrisches Ersatzschaltbild einer ersten bekannten Schaltvorrichtung in einem Gleichspannungsnetz mit quell- und lastseitigen Kapazitäten;
- Fig. 2: ein elektrisches Ersatzschaltbild einer zweiten bekannten Schaltvorrichtung in einem Gleichspannungsnetz mit quell- und lastseitigen Kapazitäten;
- Fig. 3: ein elektrisches Ersatzschaltbild, das den Aufbau eines einzelnen unidirektionalen Schaltmoduls für eine bekannte Schaltvorrichtung zeigt;
- Fig. 4: ein elektrisches Ersatzschaltbild einer seriellen Verschaltung von drei in Fig. 3 gezeigten Schaltmodulen;
- Fig. 5: ein elektrisches Ersatzschaltbild einer erfindungsgemäßen Schaltvorrichtung in einem Gleichspannungsnetz mit quell- und lastseitigen Kapazitäten; und
- Fig. 6: ein Ausführungsbeispiel eines bidirektionalen Schaltmoduls, das anstelle der Schaltmodule in den Fig. 3 bis 5 verwendet werden kann.

In der nachfolgenden Beschreibung sind gleiche Elemente mit gleichen Bezugszeichen versehen.

Fig. 3 zeigt den schematischen Aufbau eines Schaltmoduls 10 einer aus der PCT/EP2018/054775 bekannten Schaltvorrichtung 1 zum Koppeln eines quell- und lastseitige Kapazitäten umfassenden Strompfads 6. Das Schaltmodul 10 umfasst ein steuerbares Halbleiterschaltelement 13. Das steuerbare Halbleiterschaltelement 13 kann ein Bipolartransistor, ein IGBT, ein MOSFET, ein IGCT oder ein Thyristor mit einer Abschaltvorrichtung sein. Die Lastanschlüsse des steuerbaren Halbleiterschaltelements 13 sind zwischen einem ersten Schaltmodulanschluss 11 und einem zweiten Schaltmodulanschluss 12 verschaltet. Zwischen dem ersten und dem zweiten Schaltmodulanschluss 11, 12 ist ferner eine Reihenschaltung aus einem Widerstand 14 und einem Kondensator 15 angeordnet. Mit anderen Worten ist ein aus dem Widerstand 14 und dem Kondensator 15 gebildetes RC-Glied parallel zu den Lastanschlüssen des steuerbaren Schaltelements 13 geschaltet.

Die prinzipielle Funktionsweise eines solchen einzelnen Schaltmoduls der Schaltvorrichtung 1 ist wie folgt: Soll die Schaltvorrichtung 1 Strom führen, so ist das steuerbare Halbleiterschaltelement 13 leitend geschaltet. Sobald der Strompfad 6 mit Hilfe der Schaltvorrichtung 1 aufgetrennt werden soll, wird das steuerbare Halbleiterschaltelement 13 durch eine in den Figuren nicht gezeigte Steuereinheit sperrend geschaltet. Dadurch kann der in dem Strompfad 6 fließende Strom I nur noch über das aus dem Widerstand 14 und dem Kondensator 15 gebildete RC-Glied weiter fließen. Der Kondensator 15 lädt sich infolge des in ihn fließenden Stroms I auf, bis ein vorgegebener oberer Schwellwert der über ihm abfallenden Spannung erreicht ist. Hierzu kann eine entsprechende Messvorrichtung (nicht dargestellt) in dem Schaltmodul 10 vorgesehen sein. Sobald der vorgegebene obere Schwellwert erreicht ist, wird das steuerbare Halbleiterschaltelement 13 wieder leitend geschaltet. Dadurch kann sich der Kondensator 15 über den Widerstand 14 und das steuerbare Halbleiterschaltelement 13 entladen. Sobald ein vorgegebener unterer Schwellwert der über dem Kondensator 15 abfallenden Spannung erreicht ist, wird das steuerbare Halbleiterschaltelement 13 mittels seiner Steuervorrichtung wieder leitend geschaltet.

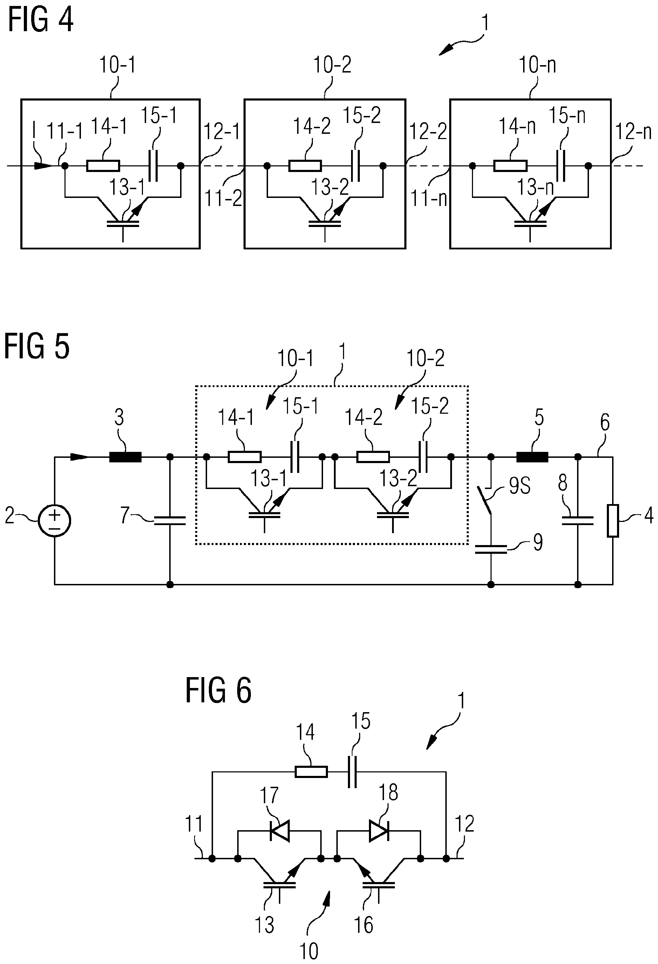

Würde die Schaltvorrichtung 1, die ursprünglich zum Auftrennen eines quell- und lastseitige Induktivitäten aufweisenden Strompfades entworfen wurde, lediglich ein einziges Schaltmodul 1, wie in Fig. 3 dargestellt, umfassen, so können lediglich Spannungen beherrscht werden, die kleiner sind als die Maximalspannung des steuerbaren Halbleiterschaltelements 13 und des Kondensator 15. Bei größeren auftretenden Spannungen könnte das steuerbare Halbleiterschaltelement 13 und/oder der Kondensator zerstört werden. Zum Auftrennen eines Strompfands eines Gleichspannungsnetzes mit höheren Spannungen, ist daher gemäß Fig. 4 das serielle Verschalten einer Mehrzahl an wie in Fig. 3 gezeigten Schaltmodulen vorgesehen. Eine derartige Schaltvorrichtung 1 mit zumindest zwei seriell verschalteten Schaltmodulen wird zum Koppeln zweier quell- und lastseitige Kapazitäten umfassenden Gleichstromnetze genutzt.

Fig. 4 zeigt ein elektrisches Ersatzschaltbild einer seriellen Verschaltung von n Schaltmodulen 10-1, 10-2, ..., 10-n (allgemein: 10-i, wobei i = 1 bis n). Jedes der Schaltmodule 10-i ist in der wie in Fig. 3 beschriebenen Weise aufgebaut. Die serielle Verschaltung der Schaltmodule 10-i erfolgt dabei derart, dass der zweite Schaltmodulanschluss 12-1 des ersten Schaltmoduls 10-1 mit dem ersten Schaltmodulanschluss 11-2 des nachfolgenden Schaltmoduls 10-2 verbunden ist, und so weiter. Der erste Schaltmodulanschluss 11-1 des ersten Schaltmoduls 10-1 ist, wie in Fig. 5 gezeigt, über eine quellseitige Induktivität 3 mit einer Gleichspannungsquelle 2 verbunden. Bei der Gleichspannungsquelle 2 kann es sich beispielsweise um eine Energieerzeugungseinheit, z.B. eine Photovoltaikanlage, ein Speichersystem, ein Batterieladegerät, eine Windenergieanlage, einen Gleichrichter und dergleichen handeln. Der zweite Schaltmodulanschluss 12-n des letzten Schaltmoduls 10-n ist, wie in Fig. 5 gezeigt, über eine lastseitige Induktivität 6 mit einer Last 4 verschaltet. Bei der Last 4 kann es sich beispielsweise um einen Antrieb eines Gleichspannungsnetzes o.ä. handeln.

Fig. 5 zeigt das elektrische Ersatzschaltbild einer Schaltvorrichtung 1, welche aus zwei seriell miteinander verschalteten Schaltmodulen 10-1 und 10-2 besteht, welche jeweils wie in Fig. 3 beschrieben, aufgebaut sind. Die Schaltvorrichtung 1 ist über die bereits erwähnte quellseitige Induktivität 3 mit der Gleichspannungsquelle 2 verbunden. Der Serienschaltung aus der Gleichspannungsquelle 2 und der quellseitigen Induktivität 3 ist ein quellseitiger Kondensator 7 parallel geschaltet. Ausgangsseitig ist die Schaltvorrichtung 1 über die lastseitige Induktivität 5 mit der Last 4 verbunden. Der Last 4 ist ein lastseitiger Kondensator 8 parallel geschaltet. Die Kondensatoren 7, 8 sind z.B. Zwischenkreiskondensatoren von Umrichtern. Ferner ist in Fig. 5 eine Serienschaltung aus einer kapazitiven Last 9 und einem Schalter 9S optional vorgesehen, wobei die Serienschaltung parallel zu dem lastseitigen Kondensator 8 angeordnet ist. Die quell- und lastseitigen Induktivitäten 3, 5 müssen nicht zwingend physikalische Komponenten des Gleichspannungsnetzes darstellen. Die quell- und lastseitigen Induktivitäten 3, 5 können auch Leitungsinduktivitäten sein.

Die Funktionsweise der in Fig. 5 gezeigten Schaltvorrichtung zur Verbindung des den Kondensator 7 aufweisenden Gleichstromnetzes mit dem den Kondensator 8 aufweisenden Gleichstromnetz ist wie folgt: Es wird davon ausgegangen, dass der Kondensator 7 des in Fig. 5 linken Gleichspannungsnetzes aufgeladen ist, während der Kondensator 8 des in Fig. 5 rechten Gleichspannungsnetzes entladen ist. Die steuerbaren Halbleiterschaltelemente 13-1, 13-2 beider Schaltmodule 10-1, 10-2 sind gesperrt. Um hohe Ausgleichsströme zwischen den Kondensatoren 7, 8 bei gleichzeitigem Leitendschalten der steuerbaren Halbleiterschaltelemente 13-1, 13-2 zu vermeiden, wird zunächst nur das steuerbare Halbleiterschaltelement eines der Module 10-1, 10-2 leitend geschaltet. Beispielsweise wird das steuerbare Halbleiterschaltelement 13-1 des Schaltmoduls 10-1 leitend geschaltet, während das steuerbare Halbleiterschaltelement 13-2 des Schaltmoduls 10-2 sperrend geschaltet bleibt. Hierdurch wird der Kondensator 15-1 des Schaltmoduls 10-1, der ebenso wie der Kondensator 15-2 des Schaltmoduls 10-2 auf halbe Busspannung geladen war, über den Widerstand 14-1 des Schaltmoduls 10-1 entladen. Gleichzeitig wird der Kondensator 15-2 des Schaltmoduls 10-2 über dessen seriell verschalteten Widerstand 14-2 auf volle Busspannung aufgeladen. Die Busspannung ist dabei die in dem linken Gleichspannungsnetz vorherrschende Spannung. Zwischen den beiden Kondensatoren 15-1, 15-2 wirkt der Widerstand 14-2 somit als Strombegrenzungswiderstand.

Anschließend wird das steuerbare Halbleiterschaltelement 13-1 des Schaltmoduls 10-1 sperrend geschaltet, während gleichzeitig oder zeitlich kurz danach das steuerbare Halbleiterschaltelement 13-2 des Schaltmoduls 10-2 leitend geschaltet wird. Hierdurch wird der Kondensator 15-2 des Schaltmoduls 10-2 über den Widerstand 14-2 entladen. Gleichzeitig wird der Kondensator 15-1 über den Widerstand 14-1 geladen, so dass zwischen den Kondensatoren 7, 8 nun der Widerstand 14-1 des Schaltmoduls 10-1 als Strombegrenzungswiderstand wirkt. Dazwischen können zeitweise auch beide Halbleiterschaltelemente wieder sperrend geschaltet werden.

Dieses Vorgehen wird nun solange wiederholt, bis sich die Spannungen der quell- und lastseitigen Kapazitäten 7, 8 aneinander angeglichen haben.

Mit der Schaltfrequenz (d.h. dem Wechsel eines Zustands, in dem das steuerbare Halbleiterschaltelement 13-1 des Schaltmoduls 10-1 leitend und das steuerbare Halbleiterschaltelement 13-2 des Schaltmoduls 10-2 sperrend geschaltet, und einem anderen Zustand, in dem die Schaltzustände umgekehrt sind), sowie dem zeitweise Sperren beider Halbleiterschaltelemente kann der mittlere Strom, der zwischen den beiden Gleichspannungsnetzen fließt, eingestellt werden. Zusätzlich kann über eine Variation des Pulsweitenverhältnisses und damit eine nur teilweise Entladung der Kondensatoren 15-1 und 15-2 der Schaltmodule 10-1, 10-2 auch der Strom in gezielter Wiese eingestellt werden. Ungeachtet dieser Stromeinstellung durch verschiedene Schaltsequenzen wird der Spitzenstrom zumindest auf den Wert begrenzt, der durch die Spannungsdifferenz der beiden Busse und einem der beiden Widerstände 14-1 und 14-2 bestimmt ist.

Weist die Schaltung, wie in Fig. 5 gezeigt, zusätzlich die mittels des steuerbaren Schalters 9S schaltbare kapazitive Last 9 auf, so kann durch den verursachten Ladestrom in dem Schalter 10 fälschlicherweise ein Kurzschluss detektiert werden. Eine solche Kurzschlussdetektion erfolgt üblicherweise durch eine in dem Schaltelement 10 vorgesehene Überwachungsschaltung. Dies kann zur Abschaltung des Schalters 10 führen. Dieses Verhalten kann vermieden werden, wenn die Abschaltung durch die Sicherheitsschaltung des Schalters 10 nicht sofort erfolgt, sondern zunächst im Chopper-Mode eine Strombegrenzung erreicht wird. Hierbei kann das in der PCT/EP2018/054775 der Anmelderin beschriebene Verfahren zum Einsatz kommen. Hierdurch bleibt Zeit, um zu detektieren, ob tatsächlich ein Kurzschluss lastseitigen Bussegment vorliegt oder nur ein vorübergehend erhöhter Ladestrom durch das Zuschalten der kapazitiven Last 9 vorliegt. Dazu kann zum einen direkt der Stromverlauf im Schalter 10 überwacht werden. Alternativ oder zusätzlich kann der Spannungsverlauf im Lastpfad 6 überwacht werden. Beim Zuschalten der kapazitiven Last 9 wird die Spannung nur kurz einbrechen, während bei einem Kurzschluss ein dauerhafter Spannungsabfall die Folge wäre.

Die Steuerung der steuerbaren Halbleiterschaltelemente 13-1, 13-2 sowie des optional vorhandenen Schalters 9S erfolgt mit Hilfe der bereits erwähnten und in den Zeichnungen nicht dargestellten Steuereinheit.

Das beschriebene Vorgehen kann, unabhängig davon, wie groß die Anzahl n der in Reihe verschalteten Schaltmodule ist, in entsprechender Weise durchgeführt werden. Welche der steuerbaren Halbleiterschaltelemente 13-i zu einem gegebenen Zeitpunkt sperrend und welche anderen steuerbaren Halbleiterschaltelemente 13-i leitend geschaltet sind, kann entweder unter gezielter Steuerung der erwähnten, jedoch nicht gezeigten, Steuereinheit erfolgen. Ebenso kann durch die geeignete, unterschiedliche Wahl jeweiliger oberer Schaltschwellen das zeitliche Verhalten des Ein- und Ausschaltens des zugeordneten steuerbaren Halbleiterschaltelements beeinflusst werden.

In einer anderen Alternative kann die über den jeweiligen Kondensatoren 15-i anliegende Spannung durch entsprechende Messmittel (nicht gezeigt) überwacht werden. Dabei wird das dem Kondensator, bei dem die höchste Spannung anliegt, zugeordnete steuerbare Halbleiterschaltelement leitend geschaltet, bis der vorgegebene untere Schwellwert erreicht ist. Da zu unterschiedlichen Zeitpunkten immer unterschiedliche Schaltmodule bzw. deren Kondensatoren eine höchste Spannung aufweisen, ergibt sich ein mehr oder minder zufälliges Ein- und Ausschalten der steuerbaren Halbleiterschaltelemente 13-i der Schaltmodule 10-i.

Fig. 6 zeigt eine Abwandlung des in Fig. 3 gezeigten Schaltmoduls 10. Zusätzlich zu dem Halbleiterschaltelement 13 ist ein weiteres Halbleiterschaltelement 16 anti-seriell zu dem steuerbaren Halbleiterschaltelement 13 verschaltet. Das steuerbare Halbleiterschaltelement 13 und das weitere steuerbare Halbleiterschaltelement 16 können vom gleichen Typ sein, z.B. IGBTs. Das Verhalten dieses bidirektional betreibbaren Schaltmoduls 10 entspricht dem Verhalten des Schaltmoduls aus Fig. 3. Der Stromfluss kann bei dem in Fig. 6 gezeigten bidirektionalen Schaltmodul 10 in beide Richtungen gerichtet sein. Dabei ist eines der beiden steuerbaren Halbleiterschaltelemente 13, 16 im leitenden Fall leitend und das andere sperrend geschaltet. Der Stromfluss wird über eine jeweilige anti-parallel geschaltete Diode 17 bzw. 18 gewährleistet.

Die beschriebene Vorrichtung kann in einer Vielzahl von Anwendungen zum Einsatz gelangen. Beispielsweise kann das stromgeregelte Vorladen einer Kapazität mit Hilfe der hier beschriebenen Schaltvorrichtung beim elektrischen Fliegen, in elektrischen Schaltgeräten industrieller Anlagen sowie in Antrieben, wie z.B. Schiffen und/oder Luftfahrzeugen, eingesetzt werden. Insbesondere lassen sich Gleichspannungsnetze mit hoher Leistungsdichte auf einfache Weise miteinander koppeln. Die Vorrichtung weist eine geringe Komplexität auf und benötigt nur eine geringe Anzahl an Bauelementen, wodurch diese mit geringem Gewicht bereitstellbar ist.

### Bezugszeichenliste

- 1: Schaltvorrichtung
- 2: Gleichspannungsquelle
- 3: quellseitige Induktivität
- 4: Last
- 5: lastseitige Induktivität
- 6: aufzutrennende Leitung
- 7: quellseitige Kapazität
- 8: lastseitige Kapazität
- 9: kapazitive Last
- 9S: Schalter
- 10: Schaltmodul
- 10-1,..., 10-n: Schaltmodul
- 11: erster Schaltmodulanschluss
- 11-1,...,11-n: erster Schaltmodulanschluss
- 12: zweiter Schaltmodulanschluss
- 12-1,...,12-n: erster Schaltmodulanschluss
- 13: Halbleiterschaltelement
- 13-1,...,13-n: Halbleiterschaltelement
- 14: Widerstand
- 14-1,...,14-n: Widerstand
- 15: Kondensator
- 15-1,...,15-n: Kondensator
- I: Strom

## Patentansprüche

1. Vorrichtung zum Koppeln zweier quell- und lastseitige Kapazitäten (7, 8) umfassenden Gleichstromnetze, wobei die Vorrichtung eine Schaltvorrichtung (1) zur Stromregelung umfasst und die Schaltvorrichtung (1) zwei in Serie verschaltete Schaltmodule (10-1, 10-2) umfasst, wobei jedes der Schaltmodule (10-1, 10-2) zumindest ein steuerbares Halbleiterschaltelement (13-1, 13-2) umfasst, dem eine Serienschaltung aus einem Widerstand (14-1, 14-2) und einem Kondensator (15-1, 15-2) parallel geschaltet ist, **dadurch gekennzeichnet, dass** eine Steuereinheit der Schaltvorrichtung (1) dazu ausgebildet ist,
a) das steuerbare Halbleiterschaltelement (13-1) eines der beiden Schaltmodule (10-1, 10-2) leitend zu schalten und gleichzeitig das steuerbare Halbleiterschaltelement (13-2) des anderen der beiden Schaltmodule (10-1, 10-2) sperrend zu schalten;
b) das steuerbare Halbleiterschaltelement (13-2) des anderen der beiden Schaltmodule (10-1, 10-2) leitend zu schalten und gleichzeitig das steuerbare Halbleiterschaltelement (13-1) des einen der beiden Schaltmodule (10-1, 10-2) sperrend zu schalten;
c) die Schritte a) und b) so lange zu wiederholen bis sich die Spannungen der quell- und lastseitigen Kapazitäten (7, 8) aneinander angeglichen haben; und
d) die steuerbaren Halbleiterschaltelemente (13-1, 13-2) der zwei Schaltmodule (10-1, 10-2) leitend zu schalten.

2. Vorrichtung nach Anspruch 1, **dadurch gekennzeichnet, dass** die Steuereinheit dazu ausgebildet ist, die Schritte a) und b) zeitlich hintereinander durchzuführen.

3. Vorrichtung nach Anspruch 1 oder 2, **dadurch gekennzeichnet, dass** die Steuereinheit dazu ausgebildet ist, durch die Zeitdauern der Durchführung der Schritte a) und/oder b) den mittleren Strom von dem einen Gleichstromnetz in das andere Gleichstromnetz einzustellen.

4. Vorrichtung nach einem der vorhergehenden Ansprüche, **dadurch gekennzeichnet, dass** die Steuereinheit dazu ausgebildet ist, durch ein Pulsweitenverhältnis der in den Schritten a) und/oder b) leitend geschalteten steuerbaren Halbleiterschaltmodule den Strom von dem einen Gleichstromnetz in das andere Gleichstromnetz einzustellen.

5. Vorrichtung nach einem der vorhergehenden Ansprüche, **dadurch gekennzeichnet, dass** eines der zwei Gleichstromnetze eine mittels eines steuerbaren Schalters schaltbare kapazitive Last umfasst, wobei die Steuereinheit dazu ausgebildet ist, die Schaltvorrichtung (1) zur Stromregelung im Chopper-Betrieb zu betreiben, wenn die Steuereinheit von dem steuerbaren Schalter ein Signal empfängt, das einen Kurzschluss signalisiert.

6. Vorrichtung nach Anspruch 5, **dadurch gekennzeichnet, dass** die Steuereinheit dazu ausgebildet ist, den Stromverlauf auszuwerten, der von dem anderen der zwei Gleichstromnetze zu dem einen der zwei Gleichstromnetze mit der schaltbaren kapazitiven Last fließt.

7. Vorrichtung nach Anspruch 5 oder 6, **dadurch gekennzeichnet, dass** die Steuereinheit () dazu ausgebildet ist, den Spannungsverlauf während des Chopper-Betriebs der Schaltvorrichtung (1) auszuwerten.

8. Verfahren zum Koppeln zweier quell- und lastseitige Kapazitäten (7, 8) umfassenden Gleichstromnetze mittels einer Schaltvorrichtung (1) zur Stromregelung, wobei die Schaltvorrichtung (1) zwei in Serie verschaltete Schaltmodule (10-1, 10-2) umfasst, wobei jedes der Schaltmodule (10-1, 10-2) zumindest ein steuerbares Halbleiterschaltelement (13-1, 13-2) umfasst, dem eine Serienschaltung aus einem Widerstand (14-1, 14-2) und einem Kondensator (15-1, 15-2) parallel geschaltet ist, wobei durch eine Steuereinheit der Schaltvorrichtung (1):
a) das steuerbare Halbleiterschaltelement (13-1) eines der beiden Schaltmodule (10-1, 10-2) leitend geschaltet und gleichzeitig das steuerbare Halbleiterschaltelement (13-2) des anderen der beiden Schaltmodule (10-1, 10-2) sperrend geschaltet wird;
b) das steuerbare Halbleiterschaltelement (13-2) des anderen der beiden Schaltmodule (10-1, 10-2) leitend geschaltet und gleichzeitig das steuerbare Halbleiterschaltelement (13-1) des einen der beiden Schaltmodule (10-1, 10-2) sperrend geschaltet wird;
c) die Schritte a) und b) so lange wiederholt werden bis sich die Spannungen der quell- und lastseitigen Kapazitäten () aneinander angeglichen haben; und
d) die steuerbaren Halbleiterschaltelemente (13-1, 13-2) der zwei Schaltmodule (10-1, 10-2) leitend geschaltet werden.

9. Verfahren nach Anspruch 8, **dadurch gekennzeichnet, dass** die Steuereinheit die Schritte a) und b) zeitlich hintereinander durchführt.

10. Verfahren nach Anspruch 8 oder 9, **dadurch gekennzeichnet, dass** die Steuereinheit die Zeitdauern der Durchführung der Schritte a) und/oder b) anpasst, um den mittleren Strom von dem einen Gleichstromnetz in das andere Gleichstromnetz auf einen bestimmten Wert einzustellen.

11. Verfahren nach einem der vorhergehenden Ansprüche, **dadurch gekennzeichnet, dass** die Steuereinheit ein Pulsweitenverhältnis der in den Schritten a) und/oder b) leitend geschalteten steuerbaren Halbleiterschaltmodule anpasst, um den Strom von dem einen Gleichstromnetz in das andere Gleichstromnetz einzustellen.

12. Verfahren nach einem der vorhergehenden Ansprüche, **dadurch gekennzeichnet, dass** eines der zwei Gleichstromnetze eine mittels eines steuerbaren Schalters schaltbare kapazitive Last umfasst, wobei die Schaltvorrichtung (1) zur Stromregelung im Chopper-Betrieb betrieben wird, wenn die Steuereinheit von dem steuerbaren Schalter ein Signal empfängt, das einen Kurzschluss signalisiert.

13. Verfahren nach Anspruch 12, **dadurch gekennzeichnet, dass** die Steuereinheit den Stromverlauf auswertet, der von dem anderen der zwei Gleichstromnetze zu dem einen der zwei Gleichstromnetze mit der schaltbaren kapazitiven Last fließt.

14. Verfahren nach Anspruch 12 oder 13, **dadurch gekennzeichnet, dass** die Steuereinheit den Spannungsverlauf während des Chopper-Betriebs der Schaltvorrichtung (1) auswertet.

15. Computerprogrammprodukt, das in den internen Speicher einer Recheneinheit geladen werden kann und Codeabschnitte umfasst, mit denen die Schritte gemäß einem der Ansprüche 8 bis 14 durchgeführt werden, wenn das Programm auf der Recheneinheit läuft.

## Claims

1. Device for coupling two DC grids comprising source-side and load-side capacitances (7, 8), wherein the device comprises a switching device (1) for current regulation and the switching device (1) comprises two series-connected switching modules (10-1, 10-2), wherein each of the switching modules (10-1, 10-2) comprises at least one controllable semiconductor switching element (13-1, 13-2), with which a series circuit comprising a resistor (14-1, 14-2) and a capacitor (15-1, 15-2) is connected in parallel,
**characterized in that** a control unit of the switching device (1) is designed to
a) switch the controllable semiconductor switching element (13-1) of one of the two switching modules (10-1, 10-2) on and at the same time switch the controllable semiconductor switching element (13-2) of the other of the two switching modules (10-1, 10-2) off;
b) switch the controllable semiconductor switching element (13-2) of the other of the two switching modules (10-1, 10-2) on and at the same time switch the controllable semiconductor switching element (13-1) of the one of the two switching modules (10-1, 10-2) off;
c) repeat steps a) and b) until the voltages of the source-side and load-side capacitances (7, 8) have aligned with one another; and
d) switch the controllable semiconductor switching elements (13-1, 13-2) of the two switching modules (10-1, 10-2) on.

2. Device according to Claim 1, **characterized in that** the control unit is designed to perform steps a) and b) temporally one after the other.

3. Device according to Claim 1 or 2, **characterized in that** the control unit is designed to set, by virtue of the durations of the performance of steps a) and/or b), the average current from the one DC grid into the other DC grid.

4. Device according to one of the preceding claims, **characterized in that** the control unit is designed to set, by virtue of a pulse width ratio of the controllable semiconductor switching modules switched on in steps a) and/or b), the current from the one DC grid into the other DC grid.

5. Device according to one of the preceding claims, **characterized in that** one of the two DC grids comprises a capacitive load which is switchable by means of a controllable switch, wherein the control unit is designed to operate the switching device (1) for current regulation in the chopper mode when the control unit receives a signal from the controllable switch which signals a short circuit.

6. Device according to Claim 5, **characterized in that** the control unit is designed to evaluate the current characteristic which flows from the other of the two DC grids to the one of the two DC grids with the switchable capacitive load.

7. Device according to Claim 5 or 6, **characterized in that** the control unit () is designed to evaluate the voltage characteristic during the chopper mode of the switching device (1) .

8. Method for coupling two DC grids comprising source-side and load-side capacitances (7, 8) by means of a switching device (1) for current regulation, wherein the switching device (1) comprises two series-connected switching modules (10-1, 10-2), wherein each of the switching modules (10-1, 10-2) comprises at least one controllable semiconductor switching element (13-1, 13-2), with which a series circuit comprising a resistor (14-1, 14-2) and a capacitor (15-1, 15-2) is connected in parallel, wherein, by means of a control unit of the switching device (1):
a) the controllable semiconductor switching element (13-1) of one of the two switching modules (10-1, 10-2) is switched on and at the same time the controllable semiconductor switching element (13-2) of the other of the two switching modules (10-1, 10-2) is switched off;
b) the controllable semiconductor switching element (13-2) of the other of the two switching modules (10-1, 10-2) is switched on and at the same time the controllable semiconductor switching element (13-1) of the one of the two switching modules (10-1, 10-2) is switched off;
c) steps a) and b) are repeated until the voltages of the source-side and load-side capacitances () have aligned with one another; and
d) the controllable semiconductor switching elements (13-1, 13-2) of the two switching modules (10-1, 10-2) are switched on.

9. Method according to Claim 8, **characterized in that** the control unit performs steps a) and b) temporally one after the other.

10. Method according to Claim 8 or 9, **characterized in that** the control unit matches the durations of the performance of steps a) and/or b) in order to set the average current from the one DC grid into the other DC grid to a specific value.

11. Method according to one of the preceding claims, **characterized in that** the control unit matches a pulse width ratio of the controllable semiconductor switching modules which are switched on in steps a) and/or b) in order to set the current from the one DC grid into the other DC grid.

12. Method according to one of the preceding claims, **characterized in that** one of the two DC grids comprises a capacitive load which is switchable by means of a controllable switch, wherein the switching device (1) for current regulation is operated in the chopper mode when the control unit receives a signal from the controllable switch which signals a short circuit.

13. Method according to Claim 12, **characterized in that** the control unit evaluates the current characteristic which flows from the other of the two DC grids to the one of the two DC grids with the switchable capacitive load.

14. Method according to Claim 12 or 13, **characterized in that** the control unit evaluates the voltage characteristic during the chopper mode of the switching device (1).

15. Computer program product which can be loaded onto the internal memory of an arithmetic logic unit and comprises code segments, with which the steps according to one of Claims 8 to 14 are performed when the program is running on the arithmetic logic unit.

## Revendications

1. Montage de connexion de deux réseaux à courant continu comprenant des capacités (7, 8) du côté source et du côté charge, dans lequel le montage comprend un montage (1) de coupure pour la régulation du courant et le montage (1) de coupure comprend deux modules (10-1, 10-2) de coupure montés en série, dans lequel chacun des modules (10-1, 10-2) de coupure comprend au moins un élément (13-1, 13-2) de coupure à semiconducteur pouvant être commandé, avec lequel est monté en parallèle un circuit série composé d'une résistance (14-1, 14-2) et d'un condensateur (15-1, 15-2), **caractérisé en ce qu'**une unité de commande du montage (1) de coupure est constituée,
a) pour mettre l'élément (13-1) de coupure à semiconducteur pouvant être commandé de l'un des deux modules (10-1, 10-2) de coupure à l'état passant et en même temps pour mettre l'élément (13-2) de coupure à semiconducteur pouvant être commandé de l'autre des deux modules (10-1, 10-2) de coupure à l'état bloqué ;
b) pour mettre l'élément (13-2) de coupure à semiconducteur pouvant être commandé de l'autre des deux modules (10-1, 10-2) de coupure à l'état passant et en même temps pour mettre l'élément (13-1) de coupure à semiconducteur pouvant être commandé de l'un des deux modules (10-1, 10-2) de coupure à l'état bloqué ;
c) pour répéter les stades a) et b) jusqu'à ce que les tensions des capacités (7, 8) du côté source et du côté charge soient égalisées l'une à l'autre ; et
d) pour mettre les éléments (13-1, 13-2) de coupure à semiconducteur pouvant être commandés des deux modules (10-1, 10-2) de coupure à l'état passant.

2. Montage suivant la revendication 1, **caractérisé en ce que** l'unité de coupure est constituée pour effectuer les stades a) et b) l'un après l'autre dans le temps.

3. Montage suivant la revendication 1 ou 2, **caractérisé en ce que** l'unité de commande est constituée pour régler, par la durée pendant laquelle on effectue les stades a) et/ou b), le courant moyen de l'un des réseaux à courant continu dans l'autre réseau à courant continu.

4. Montage suivant l'une des revendications précédentes, **caractérisé en ce que** l'unité de commande est constituée pour régler, par un rapport de largeur d'impulsion des modules à semiconducteur de puissance pouvant être commandés montés passants dans les stades a) et/ou b), le courant d'un réseau de courant continu dans l'autre réseau à courant continu.

5. Montage suivant l'une des revendications précédentes, **caractérisé en ce que** l'un des deux réseaux à courant continu comprend une charge capacitive pouvant être mise en circuit au moyen d'un interrupteur pouvant être commandé, dans lequel l'unité de commande est constituée pour faire fonctionner le montage (1) de coupure pour la régulation du courant en fonctionnement chopper, si l'unité de commande reçoit de l'interrupteur pouvant être commandé un signal, qui signale un court-circuit.

6. Montage suivant la revendication 5, **caractérisé en ce que** l'unité de commande est constituée pour évaluer la courbe du courant, qui passe de l'autre des deux réseaux à courant continu à l'un des deux réseaux à courant continu ayant la charge capacitive pouvant être mise en circuit.

7. Montage suivant la revendication 5 ou 6, **caractérisé en ce que** l'unité () de commande est constituée pour évaluer la courbe de la tension pendant le fonctionnement chopper du montage (1) de coupure.

8. Procédé de connexion de deux réseaux à courant continu comprenant des capacités (7, 8) du côté source et du côté charge au moyen d'un montage (1) de coupure pour la régulation du courant, dans lequel le montage (1) de coupure comprend deux modules (10-1, 10-2) de coupure montés en série, dans lequel chacun des modules (10-1, 10-2) de coupure comprend au moins un élément (13-1, 13-2) de coupure à semiconducteur pouvant être commandé, avec lequel est monté en parallèle un circuit série composé d'une résistance (14-1, 14-2) et d'un condensateur (15-1, 15-2), dans lequel, par une unité de commande du montage (1) de coupure :
a) on met l'élément (13-1) de coupure à semiconducteur pouvant être commandé de l'un des deux modules (10-1, 10-2) de coupure à l'état passant et en même temps on met l'élément (13-2) de coupure à semiconducteur pouvant être commandé de l'autre des deux modules (10-1, 10-2) de coupure à l'état bloqué ;
b) on met l'élément (13-2) de coupure à semiconducteur pouvant être commandé de l'autre des deux modules (10-1, 10-2) de coupure à l'état passant et en même temps on met l'élément (13-1) de coupure à semiconducteur pouvant être commandé de l'un des deux modules (10-1, 10-2) de coupure à l'état bloqué ;
c) on répète les stades a) et b) jusqu'à ce que les tensions des capacités () du côté source et du côté charge aient été égalisées l'une à l'autre ; et
d) on met les éléments (13-1, 13-2) de coupure à semiconducteur pouvant être commandés des deux modules (10-1, 10-2) de coupure à l'état passant.

9. Procédé suivant la revendication 8, **caractérisé en ce que** l'unité de commande effectue les stades a) et b) l'un après l'autre dans le temps.

10. Procédé suivant la revendication 8 ou 9, **caractérisé en ce que** l'unité de coupure adapte les durées pendant lesquelles on effectue les stades a) et/ou b), afin de régler le courant moyen de l'un des réseaux à courant continu dans l'autre réseau à courant continu à une valeur déterminée.

11. Procédé suivant l'une des revendications précédentes, **caractérisé en ce que** l'unité de commande adapte un rapport de largeur d'impulsion des modules de coupure à semiconducteur pouvant être commandés montés à l'état passant dans les stades a) et/ou b), afin de régler le courant du un réseau à courant continu dans l'autre réseau à courant continu.

12. Procédé suivant l'une des revendications précédentes, **caractérisé en ce que** l'un des deux réseaux à courant continu comprend une charge capacitive pouvant être mise en circuit au moyen d'un interrupteur pouvant être commandé, dans lequel on fait fonctionner le montage (1) de coupure pour la régulation du courant en fonctionnement en chopper, si l'unité de commande reçoit de l'interrupteur pouvant être commandé un signal, qui signale un court-circuit.

13. Procédé suivant la revendication 12, **caractérisé en ce que** l'unité de commande évalue la courbe du courant, qui passe de l'autre des deux réseaux à courant continu au un des deux réseaux à courant continu ayant la charge capacitive pouvant être mise en circuit.

14. Procédé suivant la revendication 12 ou 13, **caractérisé en ce que** l'unité de commande évalue la courbe de la tension pendant le fonctionnement en chopper du montage (1) de coupure.

15. Produit de programme d'ordinateur, qui peut être chargé dans la mémoire interne d'une unité informatique et qui comprend des parties de code, par lesquelles on effectue les stades suivant l'une des revendications 8 à 14, lorsque le programme se déroule sur l'unité informatique.
